# FASCICULE DE BREVET EUROPEEN

(11) **EP 2 325 893 B1**
(45) Date de publication et mention de la délivrance du brevet: **15.04.2015**
(21) Numéro de dépôt: 10189069.7
(22) Date de dépôt: 27.10.2010
(51) Int. Cl.: H01L 29/861, H01L 29/866, H01L 21/329

(54) **Diode de protection bidirectionnelle basse tension**
Bidirektionale Schutzdiode für niedrige Spannungen
Low voltage bidirectional protection diode

(30) Priorité: 24.11.2009 FR 0958323
(43) Date de publication de la demande: 25.05.2011
(73) Titulaire: STMicroelectronics (Tours) SAS, 37100 Tours (FR)
(72) Inventeur: Morillon, Benjamin, 37100, Tours (FR)
(74) Mandataire: Thibon, Laurent

(56) Documents cités:
- WO-A1-00/62346
- WO-A2-2008/063592
- DE-A1- 3 048 816
- US-A1- 2003 205 775
- US-A1- 2010 276 779

## Description

### Domaine de l'invention

La présente invention concerne une diode de protection bidirectionnelle basse tension, c'est-à-dire dont la tension de claquage dans les deux sens est inférieure à 10 volts, de préférence voisine de 6 volts.

### Exposé de l'art antérieur

De façon générale, les diverses techniques pour construire des diodes de protection bidirectionnelles se heurtent à des limitations quand on veut réduire la tension de claquage et plus particulièrement quand on veut obtenir une diode symétrique, c'est-à-dire présentant des tensions de claquage sensiblement égales et voisines de 6 à 10 volts. En plus, les diodes bidirectionnelles connues présentent généralement un phénomène de "snapback" selon au moins l'une ou l'autre des deux polarités, c'est-à-dire que, même si la tension à laquelle s'établit le claquage est faible, par exemple voisine de 10 volts, il se présente une brève surtension initiale, c'est-à-dire que la tension aux bornes de la diode monte à une valeur plus élevée que la valeur de consigne, par exemple à une valeur de 12 à 14 volts avant de chuter à la valeur de protection voisine de 10 volts.
DE 3048816 décrit une diode de protection bidirectionnelle.

### Résumé

Ainsi, un objet général d'un mode de réalisation de la présente invention est de pallier au moins certains des inconvénients des diodes de protection bidirectionnelles connues.

Un autre objet d'un mode de réalisation de la présente invention est de prévoir une diode de protection bidirectionnelle dont les tensions de claquage sont voisines de 6 volts dans les deux directions.

Un autre objet d'un mode de réalisation de la présente invention est de prévoir une diode de protection bidirectionnelle exempte de phénomène de "snapback".

Un autre objet d'un mode de réalisation de la présente invention est de prévoir une diode de protection bidirectionnelle de petite dimension.

Pour atteindre au moins certains de ces objets, un mode de réalisation de la présente invention prévoit une diode de protection bidirectionnelle verticale comprenant, sur un substrat fortement dopé d'un premier type de conductivité, des première, deuxième et troisième régions des premier, deuxième et premier types de conductivité, ces régions ayant toutes un niveau de dopage supérieur à 2 à 5x10¹⁹ atomes par cm³ et étant délimitées latéralement par une tranchée isolée, chacune des ces régions ayant une épaisseur inférieure à 4 µm.

Selon un mode de réalisation de la présente invention, les deuxième et troisième régions résultent d'implantations dans des couches épitaxiées d'une épaisseur inférieure à 4 µm.

Selon un mode de réalisation de la présente invention, les différentes régions sont respectivement de type P, N et P, la première région ayant un niveau de dopage maximum de l'ordre de 5x10¹⁹ atomes par cm³, la deuxième région ayant un niveau de dopage maximum de l'ordre de 10²⁰ atomes par cm³ et la troisième région ayant un niveau de dopage maximum de l'ordre de 5x10¹⁹ atomes par cm³, les sommets des courbes de dopage de chacune des régions étant distants de moins de 3 µm.

Un mode de réalisation de la présente invention prévoit un procédé de fabrication d'une diode de protection bidirectionnelle verticale comprenant les étapes suivante :
former dans un substrat fortement dopé de type P, une première région très fortement dopée de type P ;
former une première couche épitaxiée sur la structure ;
former une deuxième région fortement dopée de type N dans la première couche épitaxiée ;
former une deuxième couche épitaxiée sur la structure ;
former une troisième région fortement dopée de type P dans la deuxième couche épitaxiée ;
entourer la structure d'une tranchée d'isolement traversant les trois susdites régions.

Selon un mode de réalisation de la présente invention, les deux dernières étapes sont inversées.

Selon un mode de réalisation de la présente invention, les diverses implantations sont réalisées à des doses comprises entre 1 et 10x10¹⁶ atomes/cm².

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe illustrant une diode de protection selon un mode de réalisation de la présente invention ;
la figure 2 représente des niveaux de dopage d'un exemple de la diode de la figure 1 ; et
les figures 3A à 3F représentent des étapes successives de fabrication d'une diode de protection bidirectionnelle selon un mode de réalisation de la présente invention.

Comme cela est usuel dans le domaine de la représentation des microcomposants, les diverses vues en coupe ne sont pas tracées à l'échelle et sont seulement illustratives.

### Description détaillée

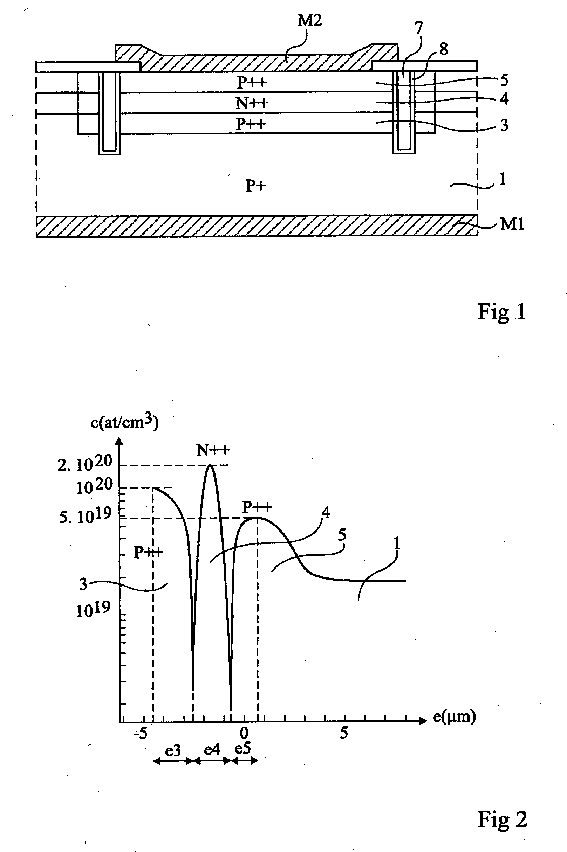

La figure 1 représente une diode de type vertical comprenant au dessus d'un substrat 1 de type P⁺ des couches successives 3, 4 et 5 très fortement dopées, respectivement de type P⁺⁺, N⁺⁺ et P⁺⁺. On entend ici par très fortement dopé, des niveaux de dopage supérieurs ou égaux à 5x10¹⁹ atomes/cm³. La face inférieure du substrat 1 est revêtue d'une métallisation M1. L'ensemble des couches 3, 4, 5 est délimité latéralement par une tranchée périphérique 7 à bords isolés 8 et la couche supérieure 5 est revêtue d'une métallisation M2. Grâce aux très forts niveaux de dopage de la base N⁺⁺ du transistor PNP, le gain de ce transistor est très faible ce qui supprime le phénomène de "snapback". On notera également que la structure a un aspect sensiblement symétrique. De plus, le fait que la structure active soit entourée d'une tranchée isolée permet d'éviter tous les phénomènes de bords et de courbure de jonction qui se produiraient aux limites du composant dans d'autres types de structure.

La figure 2 représente un exemple de niveaux de dopage choisis pour la structure de la figure 1. Cette figure 2 représente la concentration c en atomes/cm³ en fonction de l'épaisseur e en micromètres. On a indiqué les épaisseurs e3, e4 et e5 des régions 3, 4 et 5. On notera que l'épaisseur e4 de la couche N⁺⁺ 4 est de préférence de l'ordre de 2 µm. En pratique, elle sera comprise dans une plage de 1,5 à 3 µm. De même, la distance entre chacune des jonctions et la région de dopage maximum de chacune des régions P⁺⁺ 3 et 5 est de l'ordre de 2 µm, et de préférence comprise dans une plage de 1 à 3 µm.

On a indiqué le substrat 1 comme ayant une concentration de dopage comprise entre 1 et 2x10¹⁹ atomes/cm³. En effet, c'est la limite maximum de dopage des substrats commercialement disponibles. Bien entendu, si on pouvait approvisionner des substrats de plus fort niveau de dopage, la couche P⁺⁺ 3 pourrait être inutile.

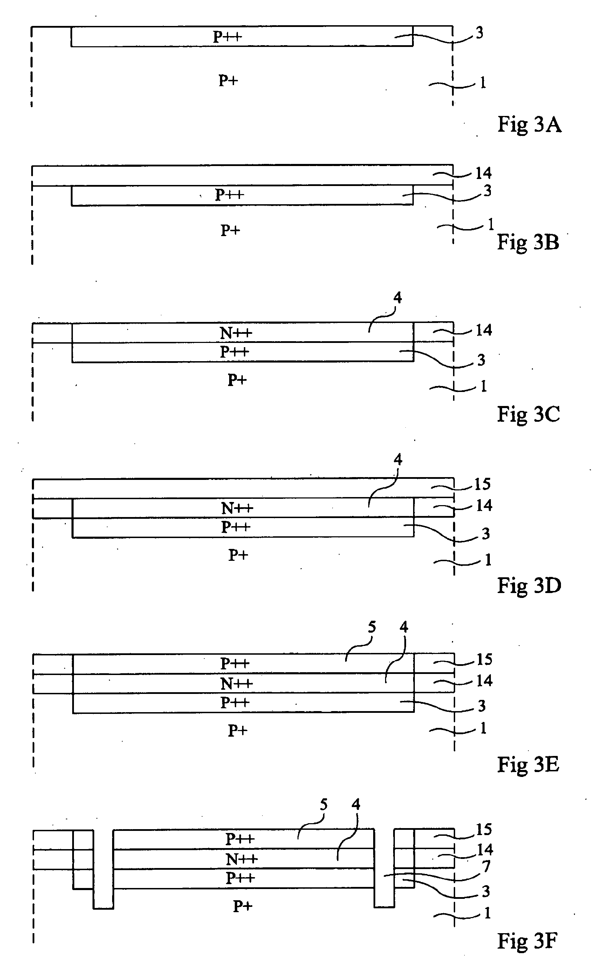

Les figures 3A à 3F illustrent des étapes successives d'un exemple de procédé de fabrication de la diode de protection bidirectionnelle de la figure 1.

Comme l'illustre la figure 3A, on part d'un substrat P⁺ 1 aussi dopé que possible, par exemple d'un niveau de dopage de 1 à 2x10¹⁹ atomes/cm³, ce qui correspond à une résistance de 5 mΩ.cm.

Sur le substrat, on réalise une implantation d'un dopant de type P, par exemple du bore à faible profondeur à la dose maximale possible, par exemple 1 à 10x10¹⁶ atomes/cm², pour atteindre en fin de processus sur une épaisseur d'environ 2 µm, un niveau de dopage maximum de l'ordre de 5x10¹⁹ atomes/cm³ . De préférence, la zone 3 est localisée, c'est-à-dire ne s'étend pas sur toute la surface du substrat, son implantation étant limitée par un masque.

Comme l'illustre la figure 3B, on réalise une épitaxie d'une couche 14 de type P ou N dont le dopage est inférieur à 5x10¹⁸ atomes/cm³, d'une épaisseur de 1 à 3 µm, par exemple de 1,5 µm.

Comme l'illustre la figure 3C, dans la couche épitaxiée 14 on réalise une implantation localisée, au-dessus de la région 3, d'un dopant de type N par exemple de l'arsenic, par exemple à une dose de 1 à 10x10¹⁶ atomes/cm², pour atteindre, sur la faible épaisseur de la couche, une concentration maximum de l'ordre de 2x10²⁰ atomes/cm³.

Comme l'illustre la figure 3D, on réalise à nouveau une épitaxie d'une couche 15 dont le dopage est inférieur à 5x10¹⁸ atomes/cm³, d'une épaisseur de 2 à 5 µm, par exemple de 3,5 µm.

Comme l'illustre la figure 3E, on réalise ensuite à travers un masque une forte implantation d'un dopant de type P par exemple du bore, par exemple à une dose de 1 à 10x10¹⁶ atomes/cm² pour atteindre dans cette couche un niveau de dopage maximum de l'ordre de 10²⁰ atomes/cm³.

A l'étape illustrée en figure 3F, on délimite la structure par une tranchée périphérique 7.

On procède alors aux étapes classiques d'isolation des parois de la tranchée, de remplissage de la tranchée par exemple par du silicium polycristallin, éventuellement oxydé, de formation de la métallisation de face avant M1, de meulage de la face arrière du substrat pour obtenir une épaisseur de l'ordre de 50 à 200 µm pour la structure, puis de formation de la métallisation de face arrière M2 pour arriver au composant illustré en figure 1.

On notera que dans la courbe de la figure 2, l'origine des épaisseurs correspond à la surface du substrat 1, les épaisseurs négatives correspondant aux couches épitaxiées.

La présente invention est susceptible de diverses variantes. Par exemple, les étapes des figures 3E et 3F peuvent être inversées, à savoir que l'on peut réaliser les tranchées d'isolement avant de réaliser la forte implantation de formation de la région P⁺⁺ 5.

Un avantage du procédé de fabrication de la présente invention est que les implantations sont réalisées à faible énergie dans des couches peu épaisses, ce qui permet de limiter la création de défauts et de limiter les étapes de recuit qui perturberaient la structure.

On constate que cette diode présente entre les métallisations M2 et M1 une tension de claquage de l'ordre de 6 volts dans les deux sens de polarisation. La tension de claquage peut être ajustée à des valeurs supérieures, par exemple jusqu'à 10 V, en modifiant les doses d'implantation ionique pour la réalisation des couches 3, 4 et 5. Les essais effectués montrent qu'aucun phénomène de snapback ne survient.

## Revendications

1. Diode de protection bidirectionnelle verticale comprenant, sur un substrat (1) fortement dopé d'un premier type de conductivité, des première (3), deuxième (4) et troisième (5) régions des premier, deuxième et premier types de conductivité, ces régions ayant toutes un niveau de dopage supérieur à 2x10¹⁹ atomes par cm³ et étant délimitées latéralement par une tranchée isolée (7), chacune de ces régions ayant une épaisseur inférieure à 4 µm.

2. Diode bidirectionnelle selon la revendication 1, dans laquelle les deuxième et troisième régions résultent d'implantations dans des couches épitaxiées d'une épaisseur inférieure à 4 µm.

3. Diode bidirectionnelle selon la revendication 1, dans laquelle les différentes régions sont respectivement de type P, N et P, la première région ayant un niveau de dopage maximum de l'ordre de 5x10¹⁹ atomes par cm³, la deuxième région ayant un niveau de dopage maximum de l'ordre de 10²⁰ atomes par cm³ et la troisième région ayant un niveau de dopage maximum de l'ordre de 5x10¹⁹ atomes par cm³, les sommets des courbes de dopage de chacune des régions étant distants de moins de 3 µm.

4. Procédé de fabrication d'une diode de protection bidirectionnelle verticale comprenant les étapes suivantes :
former dans un substrat (1) fortement dopé de type P, une première région (3) très fortement dopée de type P ;
former une première couche épitaxiée (14) sur la structure ;
former une deuxième région (4) fortement dopée de type N dans la première couche épitaxiée (14) ;
former une deuxième couche épitaxiée (15) sur la structure ;
former une troisième région (5) fortement dopée de type P dans la deuxième couche épitaxiée (15) ;
entourer la structure d'une tranchée d'isolement traversant les trois susdites régions,
dans lequel lesdites régions et couches ont toutes un niveau de dopage supérieur à 2x10¹⁹ atomes par cm³ et des épaisseurs inférieures à 4 µm.

5. Procédé selon la revendication 4, dans lequel les deux dernières étapes sont inversées.

6. Procédé selon la revendication 4, dans lequel les diverses implantations sont réalisées à des doses comprises entre 1 et 10x10¹⁶ atomes/cm².

## Patentansprüche

1. Eine vertikale Zweirichtungs-Schutzdiode, die folgendes aufweist, auf einem stark dotierten Substrat (1) eines ersten Leitfähigkeitstyps erste (3), zweite (4) und dritte (5) Zonen der ersten, zweiten und dritten Leitfähigkeitstypen, wobei alle diese Zonen einen Dotierpegel, der größer ist als von 2x10¹⁹ Atome/cm³, besitzen und seitlich begrenzt sind durch einen Isolationsgraben (7), wobei jede dieser Zonen eine Dicke von weniger als 4 µm besitzt.

2. Die Zweirichtungs-Diode nach Anspruch 1, wobei die zweiten und dritten Zonen sich aus Implantationen in Epitaxialschichten mit einer Dicke kleiner als 4 µm ergeben.

3. Die Zweirichtungs-Diode nach Anspruch 1, wobei die unterschiedlichen Zonen jeweils entsprechend dem P-Typ, dem N-Typ und dem P-Typ sind und wobei die erste Zone einen maximalen Dotierpegel in der Größenordnung von 5x10¹⁹ Atome/cm³ besitzt, die zweite Zone einen maximalen Dotierpegel in der Größenordnung von 10²⁰ Atome/cm³ besitzt und die dritte Zone einen maximalen Dotierpegel in der Größenordnung von 5x10¹⁹ Atome/cm³ besitzt, wobei die oberen Teile der Dotierkurven jeder dieser Zonen um weniger als 3 µm beabstandet sind.

4. Ein Verfahren zur Herstellung einer vertikalen Zweirichtungs-Schutzdiode, wobei die folgenden Schritte vorgesehen sind:
Formen in einem stark dotierten P-Typ Substrat (1) einer ersten sehr stark dotierten P-Typ Zone (3);
Formen einer ersten Epitaxialschicht (14) auf der Struktur;
Formen einer zweiten stark dotierten N-Typ Zone (4) in der ersten Epitaxialschicht (14);
Formen einer zweiten Epitaxialschicht (15) auf der Struktur;
Formen einer dritten stark dotierten P-Typ Zone (5) in der zweiten Epitaxialschicht (15);
Umgeben der Struktur mit einem Isolationsgraben der die drei zuvor genannten Zonen kreuzt,
wobei alle die erwähnten Zonen und Schichten einen Dotierpegel größer als 2x10¹⁹ Atome/cm³ und Dicken kleiner als 4 µm aufweisen.

5. Das Verfahren nach Anspruch 4 wobei, die letzten beiden Schritte umgekehrt sind.

6. Verfahren nach Anspruch 4, wobei die verschiedenen Implantationen mit Dosierungen im Bereich zwischen 1 und 10x10¹⁶ Atome/cm² ausgeführt werden.

## Claims

1. A vertical bidirectional protection diode comprising, on a heavily-doped substrate (1) of a first conductivity type, first (3), second (4), and third (5) regions of the first, second, and first conductivity types, these regions all having a doping level greater than from 2x10¹⁹ atoms/cm³ and being laterally delimited by an insulated trench (7), each of these regions having a thickness smaller than 4 µm.

2. The bidirectional diode of claim 1, wherein the second and third regions result from implantations in epitaxial layers having a thickness smaller than 4 µm.

3. The bidirectional diode of claim 1, wherein the different regions are respectively of type P, N, and P, the first region having a maximum doping level on the order of 5x10¹⁹ atoms/cm³, the second region having a maximum doping level on the order of 10²⁰ atoms/cm³, and the third region having a maximum doping level on the order of 5x10¹⁹ atoms/cm³, the tops of the doping curves of each of these regions being distant by less than 3 µm.

4. A method for manufacturing a vertical bidirectional protection diode, comprising the steps of:
forming in a heavily-doped P-type substrate (1) a first very heavily-doped P-type region (3);
forming a first epitaxial layer (14) on the structure;
forming a second heavily-doped N-type region (4) in the first epitaxial layer (14);
forming a second epitaxial layer (15) on the structure;
forming a third heavily-doped P-type region (5) in the second epitaxial layer (15);
surrounding the structure with an insulation trench crossing the three aforesaid regions,
wherein all said regions and layers have a doping level greater than 2x10¹⁹ atoms/cm³ and thicknesses smaller than 4 µm.

5. The method of claim 4, wherein the last two steps are inverted.

6. The method of claim 4, wherein the various implantations are performed at doses ranging between 1 and 10x10¹⁶ atoms/cm².
